# EUROPÄISCHE PATENTSCHRIFT

(11) **EP 2 662 896 B1**
(45) Veröffentlichungstag und Bekanntmachung des Hinweises auf die Patenterteilung: **15.11.2017**
(21) Anmeldenummer: 13166727.1
(22) Anmeldetag: 07.05.2013
(51) Int. Cl.: H01L 29/778, H01L 29/861

(54) **Halbleiterschichtenstruktur**
Semiconductor layer structure
Structure de couche semi-conductrice

(30) Priorität: 07.05.2012 DE 102012207501
(43) Veröffentlichungstag der Anmeldung: 13.11.2013
(73) Patentinhaber: Forschungsverbund Berlin e.V., 12489 Berlin (DE)
(72) Erfinder: Hilt, Oliver, 15566 Schöneiche (DE); Zhytnytska, Rimma, 10243 Berlin (DE); Würfl, Hans-Joachim, 15738 Zeuthen (DE)
(74) Vertreter: Gulde & Partner

(56) Entgegenhaltungen:
- WO-A1-2008/128160
- WO-A1-2013/010828
- DE-A1-102009 018 054
- US-A1- 2010 207 164
- US-A1- 2012 098 035

## Beschreibung

### Technisches Gebiet

Die Erfindung ist mit einer Halbleiterschichtenstruktur befasst. Im Einzelnen befasst sich die Erfindung mit einer Halbleiterschichtenstruktur, die eine Ableitung induktiv induzierter Spannungspulse in sperrenden aktiven Strukturen der Halbleiterschichtenstruktur ohne Schädigung der aktiven Strukturen ermöglicht.

### Stand der Technik

Beim Einsatz von Leistungstransistoren und Dioden als Schalter oder Verstärker mit induktiven Lasten müssen nach einem Ausschaltvorgang induktiv getriebene Ströme über die (sperrende) Transistor- oder Diodenstruktur abgeleitet werden ohne selbige zu schädigen. Da die induktiv getriebenen Ströme die sperrende aktive Struktur nicht passieren können, baut sich an ihr eine hohe Spannung auf, um den Stromfluss zu erzwingen. Während zum Beispiel Si-basierte Leistungstransistoren bis zu einer bestimmten Energie einen derartigen Spannungs- bzw. Strompuls tolerieren, bzw. die Pulsenergie dissipieren können (Avalanche-Festigkeit), führt dies in anderen aktiven Strukturen, zum Beispiel in GaN-basierten lateralen Transistoren (HFETs), schon bei sehr geringen Pulsenergien zu einer Schädigung des Bauelements.

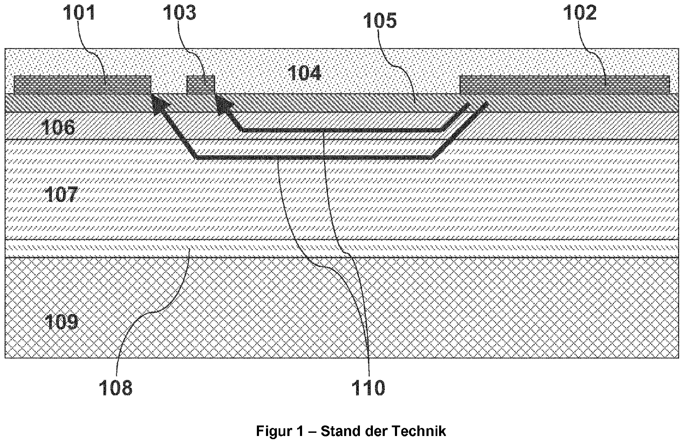

Figur 1 zeigt den schematischen Querschnitt eines derartigen GaN-basierten HFETs nach dem Stand der Technik. Im nicht sperrenden Betrieb wird nur ein Stromfluss im, typischerweise weniger als 100 nm dicken, Transistorkanal 106 benötigt. Die unter dem Transistorkanal 106 liegende Pufferschicht 107 ist mit typischerweise > 1 µm Schichtdicke wesentlich dicker als der Kanal 106. Bei sperrendem Gate 103 und hoher Spannung am Drain-Kontakt 102 fließen Leckströme 110 zwischen Drain-Kontakt und Gate-Kontakt 103 bzw. Drain-Kontakt und Source-Kontakt 101. Bei Erhöhung der Spannung am Drain-Kontakt 102 aufgrund eines induktiv getriebenen Stroms steigt der Leckstrom entlang der Strompfade 110 stark an, um die Energie des Pulses innerhalb oder unterhalb des Transistorkanals 106 zu dissipieren, also zu verteilen oder auszubreiten. Wegen des nur wenige nm dicken Transistorkanals 106 eines GaN-HFETs liegt dann eine hohe Leistungsdichte vor, die zur Schädigung des Bauelements führen kann. Zusätzlich liegt im Kanal 106 eine stark inhomogene Feldverteilung mit ausgeprägten Maxima am Gate und am Drain vor. Dies erhöht zusätzlich die Leistungsdichte an diesen Positionen.

Die Spannungsfestigkeit eines gesperrten GaN-HFETs auf leitfähigem Substrat 109 wird erstens durch den lateralen Leckstrom vom Drain-Kontakt 102 zum Source-Kontakt 101 oder Gate-Kontakt 103 innerhalb des Transistorkanals 106 und zweitens durch den vertikalen Leckstrom vom Drain-Kontakt 102 durch die Halbleiterschichten 105, 106, 107 und 108 hindurch zum Substrat 109 begrenzt.

In DE 10 2009 018 054 A1 werden zum Schutz lateraler Bauelemente an unterschiedlichen Stellen im Halbleiterstapel lateral abgegrenzte p-dotierte GaN- oder Si-Halbleitergebiete offenbart. Die dadurch erzeugten pn-Übergänge sollen die Energie der Strom/Spannungsspitzen aufnehmen. Die Energie wird dabei lateral unterhalb des Transistorkanals dissipiert oder innerhalb einer pn-Diodenstruktur im Si-Substrat.

In DE 11 2007 001 762 T5 wird eine separate Schutzstruktur zum Schutz eines Bauelements mit weiter Bandlücke vor Spannungstransienten offenbart, wobei die separate Schutzstruktur die Spannungsspitzen auffängt.

In US 7,250,641 B2 wird eine p-Typ GaN-Schicht beschrieben, die mit dem Si-Substrat eine pin-Diode formt, so dass bei einem Lawinendurchbruch erzeugte Löcher sich zwischen der Drainelektrode und dem Si-Substrat entladen können und so das (laterale) Bauelement nicht zerstört wird.

In US2010/0207164 A1 wird die Energie durch eine Diodenstruktur im Substrat abgeleitet.

### Erfindung

Die Erfindung schlägt vor, an Stelle der nach Stand der Technik zwischen einer p-Schicht und dem Si-Substrat aufgrund eines pn-Übergangs entstehenden Raumladungszone eine Pufferschicht als spannungsfestigkeitsbegrenzendes Element zu verwenden.

Im Einzelnen wird eine Halbleiterschichtenstruktur nach Anspruch 1 mit einem Substrat und einer auf dem Substrat aufgebrachten Pufferschicht vorgeschlagen.

Erfindungsgemäß ist die Halbleiterschichtenstruktur dadurch gekennzeichnet, dass durch eine Stärke der Pufferschicht und/oder eine Ionenimplantation des Substrats eine Ableitspannungsschwelle festgelegt ist, die eine Spannung zwischen einer durch die Pufferschicht vom Substrat getrennten Ladung und einem Potenzial des Substrats überschreiten muss, damit die Ladung durch die Pufferschicht zum Substrat hin abfließen kann.

Diese Struktur eignet sich besonders zum Tragen einer aktiven Halbleiterstruktur und ihrem Schutz vor Beschädigungen durch induktiv getriebene Ströme. Der erfindungsgemäße Ansatz ist, die vergleichsweise dicke Pufferschicht zur vertikalen Ableitung von Überspannungspulsen zum Substrat zu nutzen. Durch ihr großes Volumen entsteht dabei im Puffer nur eine geringe Leistungsdichte, so dass in einer derartigen Struktur wesentlich mehr Energie schädigungsfrei dissipiert werden kann als im Transistorkanal. Da das Halbleitervolumen des Puffers bereits in GaN-HFETs vorhanden ist, muss durch die Integration der vertikal stromleitenden Schutzstruktur keine zusätzliche Chipfläche eingesetzt werden.

In einer Ausführungsform ist auf der Pufferschicht eine aktive Halbleiterstruktur aufgebracht, wobei die aktive Halbleiterstruktur eine durch Aufbringen einer Barriereschicht als Kanal ausgebildeten Schicht und auf der Barriereschicht aufgebrachte Kontakte umfasst. Dabei ist die Halbleiterstruktur ausgebildet, einen Stromfluss von einem der Kontakte zu einem anderen der Kontakte durch die Schicht zumindest in einer ersten Richtung dauerhaft oder temporär zu verhindern oder zu begrenzen, sofern ein Potenzial des einen der Kontakte um weniger als eine Durchbruchsspannungsschwelle von einem Potenzial des anderen der Kontakte abweicht. Die Halbleiterstruktur ist dadurch gekennzeichnet, dass das Potenzial des Substrats dem weiteren Potenzial des anderen der Kontakte entspricht und die Ableitspannungsschwelle geringer als die Durchbruchsspannungsschwelle ist. So können induktiv induzierte Spannungen durch die Pufferschicht vertikal zum Substrat abgeleitet werden.

Weitere Ausführungsformen sind in den abhängigen Ansprüchen beschrieben.

### Zeichnungen

Ausführungsbeispiele der Erfindung werden anhand der Zeichnungen und der nachfolgenden Beschreibung näher erläutert.

Es zeigen:
- Figur 1: einen schematischen Querschnitt eines GaN-basierten HFETs nach dem Stand der Technik und mögliche zerstörerische Strompfade,
- Figur 2: einen schematischen Querschnitt eines ersten Ausführungsbeispiels der Erfindung,
- Figur 3: eine Abhängigkeit eines Substratleckstroms von der Schichtstärke einer Pufferschicht am Beispiel einer kohlenstoffdotierten GaN-Pufferschicht,
- Figur 4: einen schematischen Querschnitt eines zweiten Ausführungsbeispiels der Erfindung, und
- Figur 5: am Beispiel eines auf n-leitfähigem SiC-Substrat gewachsenen kohlenstoffdotierten GaN-Puffers die Abhängigkeit des vertikalen Leckstroms zum Substrat hin für ionenimplantiertes und nicht ionenimplantiertes Substratgebiet.

### Ausführungsformen der Erfindung

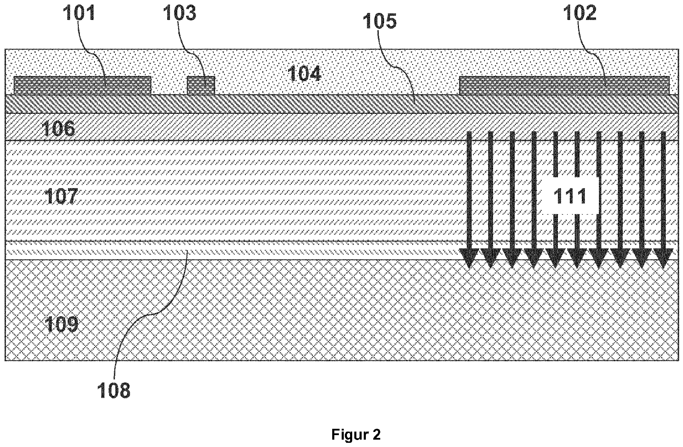

Ein schematischer Querschnitt eines ersten Ausführungsbeispiels der erfindungsgemäßen Halbleiterschichtenstruktur ist in Figur 2 dargestellt. Auf einem leitfähigen Substrat 109 sind eine optionale Anwachsschicht 108 und darauf ein Puffer 107 angeordnet. Der Puffer 107 ist im Vergleich zu einer auf dem Puffer 107 zur Ausbildung einer aktiven Struktur aufgebrachten Schicht 106 dick. Die aktive Struktur kann dabei zumindest als Diode oder Transistor ausgebildet werden.

Im dargestellten Beispiel stellt die Schicht 106 einen Transistorkanal eines GaN-HFETs dar, der neben der Schicht 106 noch eine auf der Schicht 106 angeordnete Barriereschicht 105 umfasst. Die Schicht 106 des beispielhaften GaN-HFET ist per se nicht leitfähig. Das für die Eignung als Transistorkanal notwendige zweidimensionale Elektronengas (2DEG) bildet sich in der Schicht 106 an der Grenze zur Barriere 105 erst dann aus, wenn die Barrierenschicht 105, aus zum Beispiel AIGaN im Falle eines GaN-HFETs, auf der Schicht 106 gewachsen ist. Als GaN-Dioden oder GaN-HFETs ausgebildete aktive Strukturen umfassen weiterhin auf der Barriereschicht 105 angeordnete Source- 101 und Drain-Kontakte 102. Bei Ausbildung als Transistor ist zwischen Source- 101 und Drain-Kontakt 102 noch ein Gate-Kontakt 103 angeordnet. Im Beispiel aus Figur 2 sind die aktiven Strukturen durch eine Passivierung 104 bedeckt und geschützt.

Die Stärke der Pufferschicht 107 ist entsprechend ihrem vertikalen Stromleitfähigkeitsverhalten ausgewählt. Die Wahl ist so, dass sie oberhalb einer Ableitspannung innerhalb der Halbleiterstruktur des beispielhaften GaN-Transistors einen alternativen vertikalen Strompfad 111 zur Energiedissipation eröffnet. Der Strompfad liegt im dargestellten Beispiel zwischen einem ohmschen (Drain-) Kontakt 102 auf der Halbleiteroberfläche und dem leitfähigen und auf Source-Potenzial liegenden Substrat 109, auf dem die Halbleiterschichten 108, 107, 106 und 105 gewachsen sind. Der Großteil des Spannungsabfalls zwischen Drain-Kontakt 102 und Substrat 109 soll dabei im GaN-basierten Halbleiterpuffer 107 abfallen. Dabei kann die Pulsenergie innerhalb des Puffers 107 im großen Volumen desselbigen mit geringer Leistungsdichte dissipieren. Dieses Volumen ist durch die Pfeile 111 in Figur 2 gekennzeichnet. Zur Energiedissipation von induktiv getriebenen Strompulsen am Drain 102 eines geschlossenen GaN-HFETs muss daher nicht mehr der Strompfad 110 aus Figur 1 mit seiner hohen Leistungsdichte eingesetzt werden.

Alternativ kann das Substrat auf Drain-Potenzial liegen und der Strompfad 111 zwischen einem Source-Kontakt 101 und dem Substrat 109 vorhanden sein.

Durch Einstellung der Schichtdicke des Puffers 107 und/oder selektive Ionenimplantation des Substrats kann festgelegt werden, dass der alternative vertikale Strompfad 111 bereits bei Spannungen unterhalb der durch die lateralen Transistorabmessungen, wie zum Beispiel dem Gate-Drain-Abstand, festgelegten Durchbruchspannung des Transistors verfügbar wird. Alternativ oder zusätzlich kann festgelegt werden, dass der alternative vertikale Strompfad 111 erst oberhalb einer Arbeitsspannungsschwelle verfügbar wird, wobei im sperrenden Betrieb der aktiven Struktur die Arbeitsspannungsschwelle nicht dauerhaft überschritten wird.

Oberhalb der Arbeitsspannungsschwelle zeigt der Substratleckstrom durch die erfindungsgemäßen Halbleiterstrukturen 106...108 in Figur 2 typischerweise einen exponentiellen (in allen Fällen jedoch superlinearen oder plötzlichen) Anstieg mit der Spannung.

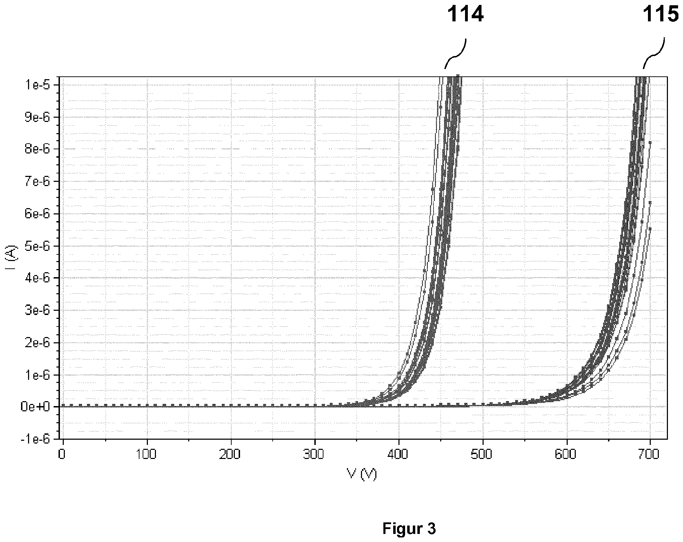

Figur 3 zeigt die Abhängigkeit des vertikalen Leckstroms von der Dicke des Puffers und der Stärke der anliegenden Spannung am Beispiel eines kohlenstoffdotierten GaN-Puffers, wobei der vertikale Leckstrom durch den Puffer zum Substrat fließt. Die Messungen 114 bei einer Pufferschichtstärke von 3 µm zeigen, dass der Substratleckstrom bis zu einer Spannung von 300 Volt vernachlässigbar und steigt bei Spannungen über 400 Volt stärker als linear an. Die Messungen 115 bei einer Pufferschichtstärke von 4 µm zeigen, dass der Substratleckstrom bis zu einer Spannung von 500 Volt vernachlässigbar und erst bei Spannungen über 600 Volt stärker als linear ansteigt. Es ist eine Erhöhung der Sperrfähigkeit des 4 µm starken Puffers um etwa 150-200 V gegenüber dem 3 µm starken Puffer erkennbar.

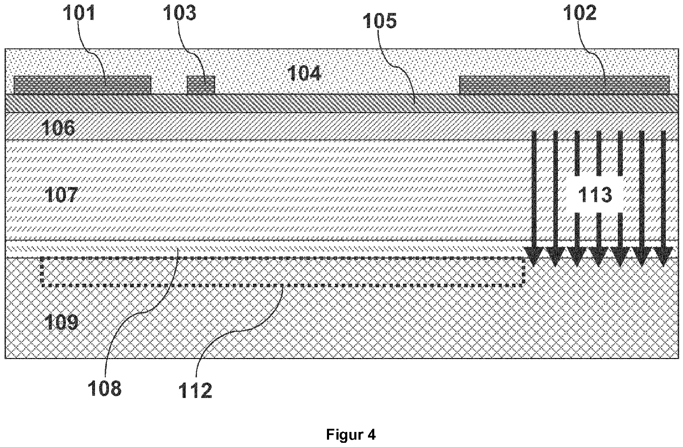

Figur 4 zeigt beispielhaft, wie durch eine geeignete selektive Ionenimplantation der Substratgebiete 112 in einem Bereich, über dem in vertikaler Richtung der Drain-Kontakt 102 aufgebracht werden soll oder wird, auf Gebiete 113 außerhalb der aktiven Transistorstruktur verlagert werden kann und diese somit weiter geschützt wird. Auch können durch geeignete laterale Dimensionierung der implantierten Gebiete 112 und des Drain-Kontakts 102 die Position und das Volumen der Energiedissipation bestimmt werden, um zum Beispiel die lokale Erwärmung des Transistors zu kontrollieren.

Wird an den lateralen Positionen der Transistorstruktur vor dem Wachstum der Halbleiterschichten 107 und 108 das leitfähige Substrat 109 (zum Beispiel Si oder dotiertes SiC) an der Oberfläche isolationsimplantiert, kann der Substratleckstrom in der Halbleiterstruktur reduziert werden. Dabei erzeugt eine Implantation im Bereich von einigen 100 keV eine zusätzliche isolierende Schicht 112 im Substrat 109.

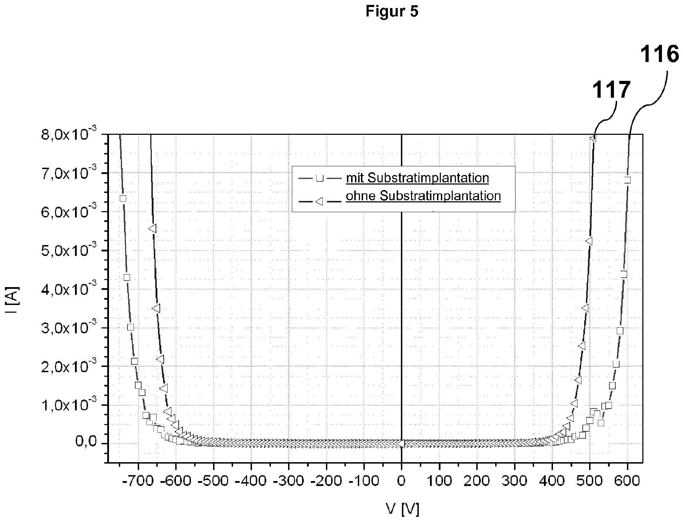

Figur 5 zeigt am Beispiel eines kohlenstoffdotierten GaN-Puffers mit n-leitfähigem SiC als Substrat die Abhängigkeit des vertikalen Leckstroms zum Substrat hin von einer Argon-Implantation im Substrat und der Stärke der anliegenden Spannung. Hier ist erkennbar, dass mit Ar-Implantation, Messungen 116, und ohne Ar-Implantation, Messungen 117, oberhalb von 400 Volt der Substratleckstrom stark ansteigt, wobei mit Ar-Implantation (durch Quadrate gekennzeichnete Messpunkte) der Anstieg deutlich schwächer ist als ohne Ionenimplantation (durch Dreiecke gekennzeichnete Messpunkte), so dass die Sperrfähigkeit mittels geeigneter Ar-Implantation um mindestens 100 V erhöht werden kann. Die Wahl des implantierten Stoffs und der Dichte und der Energien, mit der der Stoff implantiert wird, erlauben die genaue Einstellung der Sperrfähigkeit und der Ableitspannung.

### Bezugszeichenliste

- 101: Sourcekontakt
- 102: Drain-Kontakt
- 103: Gate-Kontakt
- 104: Passivierung
- 105: Barriere
- 106: Transistorkanal
- 107: Puffer-Halbleiterschicht
- 108: Anwachsschicht
- 109: leitfähiges Substrat auf Source-Potenzial
- 110: laterale Strompfade
- 111: vertikale Strompfade
- 112: isolationsimplantiertes Substrat
- 113: eingegrenzte vertikale Strompfade
- 114: Messkurven des vertikalen Leckstroms bei 3 µm Pufferschichtstärke
- 115: Messkurven des vertikalen Leckstroms bei 4 µm Pufferschichtstärke
- 116: Messpunkte des vertikalen Leckstroms mit Ar-Implantation
- 117: Messpunkte des vertikalen Leckstroms ohne Ar-Implantation

## Patentansprüche

1. Halbleiterschichtenstruktur mit einem Substrat (109), einer auf dem Substrat (109) aufgebrachten Pufferschicht (107) und einer auf der Pufferschicht (107) aufgebrachten aktiven Halbleiterstruktur, mit einer durch Aufbringen einer Barriereschicht als Kanal ausgebildeten Schicht (106), und auf der Barriereschicht aufgebrachten Kontakten, wobei die Halbleiterschichtenstruktur ausgebildet ist, einen lateralen Stromfluss von einem der Kontakte zu einem anderen der Kontakte durch die Schicht (106) zumindest in einer ersten Richtung dauerhaft oder temporär zu verhindern oder zu begrenzen, sofern ein Potenzial des einen der Kontakte um weniger als eine Durchbruchsspannungsschwelle von einem weiteren Potenzial des anderen der Kontakte abweicht, wobei ein Potenzial des Substrats (109) dem weiteren Potenzial entspricht und durch nur in einem Bereich (102) des Substrats (109) selektiv in das Substrat (109) implantierte Isolationsionen eine Ableitspannungsschwelle geringer als die Durchbruchsspannungsschwelle festgelegt ist, wobei Ladung von dem einen Kontakt durch die Pufferschicht (107) zum einem Substratgebiet ohne Isolationsionen hin abfließen kann, sofern das eine Potenzial mindestens um die Ableitspannungsschwelle von dem weiteren Potenzial abweicht, wobei das Substratgebiet ohne Isolationsionen unter dem einen Kontakt liegt, wobei in einem Querschnitt durch die Halbleiterstruktur ein erstes Schnittflächenteil der Schicht (106) im Bereich zwischen dem einen der Kontakte und dem anderen der Kontakte kleiner ist als ein zweites Schnittflächenteil eines vertikalen Bereichs zwischen dem einen der Kontakte und dem Substratgebiet ohne Isolationsionen.

2. Halbleiterschichtenstruktur nach Anspruch 1, wobei die Ableitspannungsschwelle größer als eine Mindestspannung ist, die zwischen dem einen der Kontakte und dem anderen der Kontakte dauerhaft bestehen kann, ohne dass ein die Halbleiterstruktur schädigender Stromfluss auftritt.

3. Halbleiterschichtenstruktur nach einem der Ansprüche 1 bis 2, wobei, die implantierten Isolationsionen eine Bildung eines pn-Übergangs in mindestens einem Bereich auf einer Oberfläche des Substrats (109), auf der die Pufferschicht (107) aufgebracht ist, umfassen.

4. Halbleiterschichtenstruktur nach einem der Ansprüche 1 bis 3, wobei die aktive Halbleiterstruktur einen Transistor bildet und einen zwischen den Kontakten auf der Barriereschicht aufgebrachten Gate-Kontakt (103) umfasst.

5. Halbleiterschichtenstruktur nach einem der Ansprüche 1 bis 3, wobei die aktive Halbleiterstruktur zusammen mit dem einen der Kontakte und dem anderen der Kontakte eine Diode bildet.

## Claims

1. Semiconductor layer structure having a substrate (109), a buffer layer (107) deposited onto the substrate (109), and an active semiconductor structure deposited onto the buffer layer (107) which includes a layer (106) formed as a channel by depositing a barrier layer, and contacts deposited onto the barrier layer, wherein the semiconductor layer structure is formed to permanently or temporarily prevent or limit a lateral flow of current from one of the contacts to another one of the contacts through the layer (106) at least in a first direction if a potential of the one of the contacts deviates from another potential of the other one of the contacts by less than a breakdown voltage threshold, wherein a potential of the substrate (109) corresponds to the other potential and a drain voltage threshold lower than the breakdown voltage threshold is determined by isolating ions which are selectively implanted into the substrate (109) in only one region (102) of the substrate (109), wherein charge can dissipate from the one contact toward the one substrate region without isolating ions through the buffer layer (107) if the one potential deviates from the other potential at least by the drain voltage threshold, wherein the substrate region without isolating ions is located underneath the one contact, wherein, in a cross section through the semiconductor layer structure, a first sectional area part of the layer (106) in the region between the one of the contacts and the other one of the contacts is smaller than a second sectional area part of a vertical region between the one of the contacts and the substrate region without isolating ions.

2. Semiconductor layer structure according to claim 1, wherein the drain voltage threshold is greater than a minimum voltage which can permanently exist between the one of the contacts and the other one of the contacts without the occurrence of a current flow that damages the semiconductor structure.

3. Semiconductor layer structure according to any of the claims 1 to 2, wherein the implanted isolating ions comprise a formation of a PN-junction in at least one region on a surface of the substrate (109) onto which the buffer layer (107) is deposited.

4. Semiconductor layer structure according to any of the claims 1 to 3, wherein the active semiconductor structure forms a transistor and comprises a gate contact (103) deposited between the contacts on the barrier layer.

5. Semiconductor layer structure according to any of the claims 1 to 3, wherein the active semiconductor structure forms a diode with the one of the contacts and the other one of the contacts.

## Revendications

1. Structure de couche semi-conductrice, ayant un substrat (109), une couche tampon (107) déposée sur le substrat (109) et une structure semi-conductrice active déposée sur la couche tampon (107) qui comprend une couche (106) formée en tant que canal par dépôt d'une couche barrière et des contacts déposés sur la couche barrière, la structure de couche semi-conductrice étant conçue pour empêcher ou limiter de manière permanente ou temporaire un écoulement de courant latéral à partir de l'un des contacts à un autre des contacts à travers la couche (106), au moins dans une première direction, si le potentiel de l'un des contacts s'écarte de moins d'un seuil de tension de claquage d'un autre potentiel de l'autre des contacts, un potentiel du substrat (109) correspondant à l'autre potentiel, et un seuil de tension de drain inférieur au seuil de tension de claquage étant déterminé par des ions isolants implantés sélectivement dans le substrat (109) dans seulement une région (102) du substrat (109), une charge pouvant être dissipée à partir de l'un contact vers l'une région du substrat sans ions isolants à travers la couche tampon (107) si l'un potentiel s'écarte de l'autre potentiel au moins du seuil de tension de drain, la région du substrat sans ions isolants étant située au-dessous de l'un contact, et, dans une section transversale à travers la structure semi-conductrice, une première partie de surface de coupe de la couche (106) située dans la région entre l'un des contacts et l'autre des contacts étant inférieure à une deuxième partie de surface de coupe d'une région verticale située entre l'un des contacts et la région du substrat sans ions isolants.

2. Structure de couche semi-conductrice selon la revendication 1, dans laquelle le seuil de tension de drain est supérieur à une tension minimale qui peut exister de manière permanente entre l'un des contacts et l'autre des contacts sans l'occurrence d'un écoulement de courant nuisant à la structure semi-conductrice.

3. Structure de couche semi-conductrice selon l'une des revendications 1 à 2, dans laquelle les ions isolants implantés comprennent une formation d'une jonction PN dans au moins une région sur une surface du substrat (109) sur laquelle est déposée la couche tampon (107).

4. Structure de couche semi-conductrice selon l'une des revendications 1 à 3, dans laquelle la structure semi-conductrice active forme un transistor et comprend un contact de grille (103) déposé entre les contacts sur la couche barrière.

5. Structure de couche semi-conductrice selon l'une des revendications 1 à 3, dans laquelle la structure semi-conductrice active forme une diode avec l'un des contacts et l'autre des contacts.
